# EUROPEAN PATENT APPLICATION

(11) **EP 2 528 108 A1**
(43) Date of publication of application: **28.11.2012**
(21) Application number: 12166600.2
(22) Date of filing: 03.05.2012
(51) Int. Cl.: H01L 31/048, H01L 31/052

(54) **Special component for photovoltaic applications**

(30) Priority: 03.05.2011 IT RM20110227
(71) Applicant: Magaldi Industrie S.R.L., 84135 Salerno (IT)
(72) Inventor: Cataneo, Giancarlo, Salerno (IT)
(74) Representative: Papa, Elisabetta

(57) **Abstract**

The present invention refers to special unit comprising a plurality of photovoltaic panels, suitable to be installed on plane roofs of factories, buildings or industrial sheds in general, and to be integrated in the structure and architecture of the latter or in replacement of such covering (Fig. 5).

## Description

### Field of the Invention

The present invention refers to a special unit comprising a plurality of photovoltaic panels, suitable to be installed on plane roofs of factories, buildings or industrial sheds in general, and integrated in the structure and architecture of the latter, or in replacement of such a roof covering thereof.

### Background of the Invention

The art is aware of the use of photovoltaic systems connected to a pre-existing power network and able to inlet into the latter the power production exceeding the own consumption of a user managing the system.

Typically, in case of photovoltaic systems associated with industrial realities the best positioning of the photovoltaic panels is on factory roofs, free from shadows and facing South.

In the presence of plane roofs, generally of carpentry or cement, the tilt (pitch) of the roof itself is by definition lower than 6° with respect to the horizontal. However, an arrangement of the photovoltaic panels according to such tilt would markedly reduce the efficiency of the panels themselves, whereas in order to obtain an effective tilt bulky superstructures should be pre-arranged, straying from the purpose of architectural integration and overloading the existing structures and floors.

Moreover, current regulations governing the erection of an on-roof photovoltaic system are not always compatible with those related to the erection of the building envelope itself. In particular, the latter has to be fire- and impact-resistant, whereas the photovoltaic panels are not

On the basis of what has been set forth hereto, evidently the opposing needs, on the one hand of an architectural integration in industrial buildings (possibly without overloading for floors and structures) and on the other hand of maintaining high safety standards, particularly in the presence of fires, do not find an optimal compromise in the known art.

Moreover, another important need, always related to the above-mentioned safety standards, is that of ensuring a resistance to strong impacts, such that even when a panel glazing breaks no person inside the building may be harmed, nor the panels may allow in-floor penetration of items potentially dangerous for building occupants.

### Summary of the Invention

Therefore, the technical problem at the basis of the present invention is that of overcoming the drawbacks mentioned above with reference to the known art, by providing a single special component able to solve the different problems correlated to industrial factory coverings, in terms of architectural integration and compliance with safety standards.

The above-mentioned problem is solved by a photovoltaic unit according to claim 1. Preferred features of the invention are set forth in the dependent claims.

As mentioned above, and as will hereinafter be better appreciated also in connection with preferred embodiments of the invention, the proposed photovoltaic unit represents a special component made so as to preserve architectural integration, though leaving unaltered the safety standards set by current regulations.

The proposed photovoltaic unit meets power production needs, guaranteeing and improving the performances of the building component that replaces, in particular, the roof or a part thereof.

Preferably, the photovoltaic unit of the invention integrates standard-type photovoltaic panels, mounted on a supporting structure that acts as interface with the existing floor or replaces it, and that is designed to decrease loads on roofs and maximize power production.

According to a preferred embodiment, the photovoltaic unit further provides a main exposure wall on which the photovoltaic panels and a plurality of side walls circumscribing said exposure wall are mounted, the latter made in the form of laminated products, preferably of class B-s1 d0 polycarbonate and apt to allow inletting of indirect light into the building and, in case of fire, quick disposal of great amounts of fumes and of the related fire load.

Moreover, preferably the photovoltaic unit of the invention comprises fretted sheet metals or equivalent elements arranged below the photovoltaic panels, which, among the numerous advantages described hereinafter, allow improved rainwater tightness and attain an optimal thermal regulation of the building on which the photovoltaic unit itself is installed. In connection with this latter aspect, the use of said fretted sheet metals - or anyhow the provision of aeration channels below an exposure wall integrating the photovoltaic panels - enables the onsetting of convective motions which force a continuous change of the air underlying the photovoltaic panels and increase the efficiency of the panels themselves, as said motions reduce the operating temperature thereof.

Other advantages, features and the operation steps of the present invention will be made apparent in the following detailed description of some embodiments thereof, given by way of example and not for limitative purposes.

### Brief description of the Figures

Reference will be made to the figures of the annexed drawings, wherein:
- Fig. 1 shows a schematic front axonometric view of a preferred embodiment of the photovoltaic unit of the present invention;
- Fig. 2 shows a schematic rear axonometric view of the photovoltaic unit of Fig. 1,
- Fig. 3 shows a schematic top plan view of an installation of a plurality of photovoltaic units, each like that of Fig. 1, on a plane roof of an industrial shed;
- Fig. 4 shows a sectional view of the installation of Fig.3, taken along line A-A of the latter figure;
- Fig. 5 shows a side view of a unit according to Fig 1 in the installation of Fig. 3; and
- Fig. 5A shows a side view of a unit according to Fig. 1 in a preferred installation variant.

### Detailed description of preferred embodiments

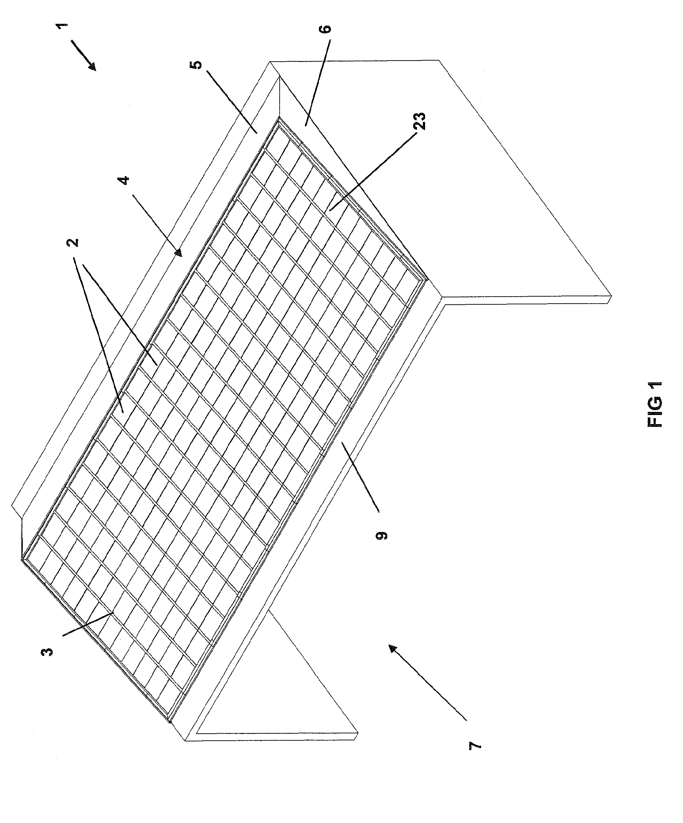

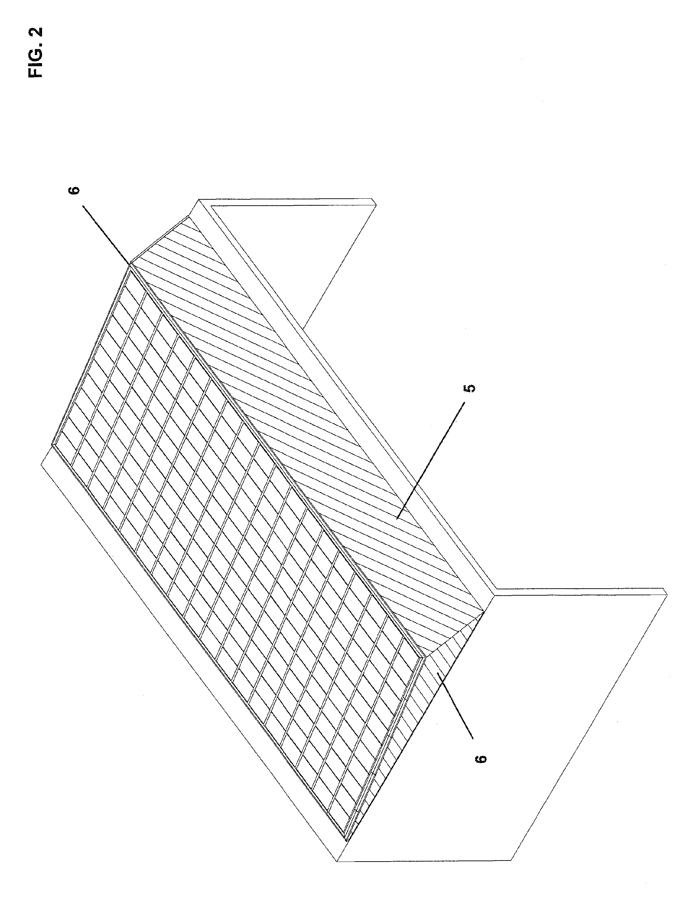

Referring to Figures 1 and 2, a photovoltaic unit according to a preferred embodiment of the invention is generally denoted by 1.

The photovoltaic unit 1, in the example considered herein, is suitable to be positioned in association with, or in replacement of, a plane roof or floor 9 of a building 7.

The photovoltaic unit 1 comprises first of all a plurality of photovoltaic panels, each denoted by 2, arranged side-by-side and each equipped with its own frame 3 contouring the actual photovoltaic module. The photovoltaic panels 3 can be of known type, and therefore a further description thereof will be omitted. Preferably, they are of series-connected type

The plurality of photovoltaic panels 2 is supported by a supporting structure, generally denoted by 4, which in the example considered herein rests on the structure of the floor 9.

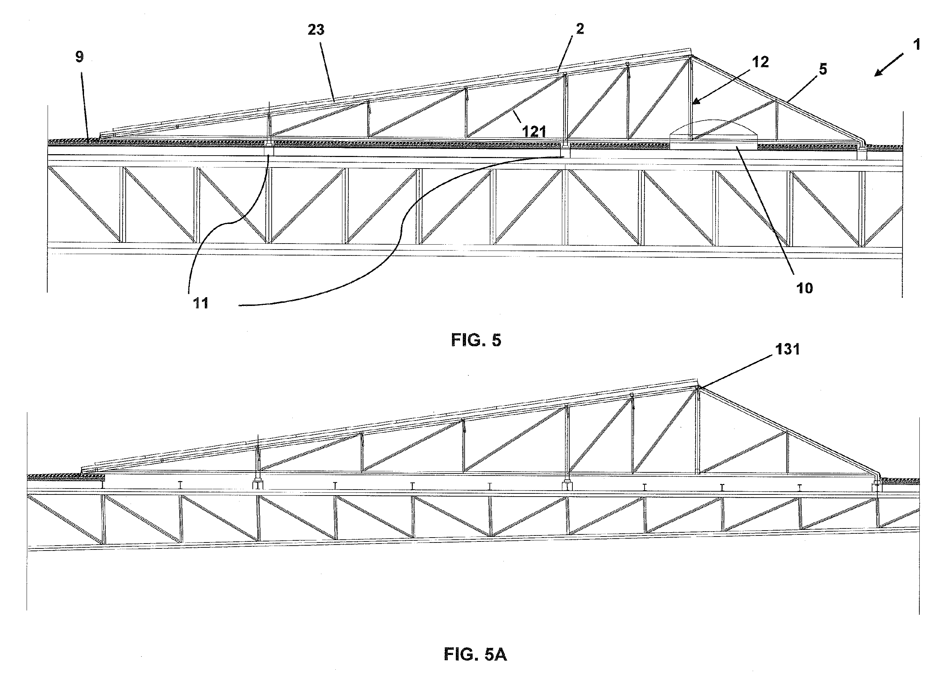

The supporting structure 4 in turn comprises:
- a tilted exposure wall 23, made of the photovoltaic panels 2 so as to be exposed, in use, to solar radiation;
- a plurality of side walls contouring the exposure wall 23; and
- a mast-type load-bearing frame 12, the latter best seen in Figure 5, arranged, in use, below the exposure wall 23.

Always referring to Figures 1 and 2, in the present example three side walls, and in particular a tilted rear wall 5 and two side walls 6, are provided.

The overall geometry of the photovoltaic unit 1 is substantially that of a quadrilateral-based scalene pyramid, with an exposure wall 23 having a substantially rectangular plan, in which the rear wall 5 is arranged at a long side of the exposure wall 23 and the side walls 6 are arranged one per each short side. The overall arrangement is such as to give to the photovoltaic panels 2 an orientation favourable to solar exposure (Southward) and a tilt with respect to the ground apt to obtain maximum power production.

Optimal tilt for the panels is a function of latitude; for Italy as a country, such tilt is of about 30°, but in that case the photovoltaic panels generate a very long shadow, therefore the number of panels on the roof surface and the related installable power decreases. At our latitudes, considering yield and installable power, an optimum tilt is attained at about 15° As to orientation, however, it is always worthwhile to orient the special components with the photovoltaic surfaces facing South.

In this connection, the tilt of the rear wall 5 is such as to ensure, in case of an in-series installing of plural units 1, that each unit does not cast a shadow on the photovoltaic panels of the adjacent unit(s).

The side walls 5 and 6 of unit 1 are entirely or at least partially made of a transparent, shock-resistant, fire-retardant and self-extinguishing material, preferably class B-s1 d0 polycarbonate according to European fire-prevention standards, in particular EN 13501-1:2007 +A1:2009

The use of such self-extinguishing fire-retardant material allows, in case of fire in environments beneath the building 7, a reaction of the material itself to fire such as to eliminate stagnation zones for heat and fumes under the roof, thereby resulting in a natural escape route and eliminating the risk of collapse of the structures in case operating temperatures envisaged therefor are exceeded.

Moreover, making such walls 5, 6 transparent allows an inletting of light in the building 7, with an entailed decided reduction of power consumptions in the building itself. In this connection, a direct consequence of the presence of the wall 5 facing North is that such light being inlet is indirect and diffused, therefore without exposure to direct solar irradiation and without additional heat in summertime.

The side walls 5 and 6 may have shockproof properties, inherent in the material constituting them and improved, e.g., by a lattice-shaped shockproof member.

In the present example it is envisaged, for each wall 5, 6, the use of a galvanized wire netting placed beneath, and supporting a main body of polycarbonate Preferably, such a wire netting has a square mesh, e.g. of a (10x10) cm pitch

The presence of such a wire netting - or of an equivalent member - allows increasing the safety factor for any shocks to which the walls 5 and 6 may be subjected. Moreover, in the above-considered example, the wire netting or equivalent shockproof member allows to utilize a main body of polycarbonate of minimum thickness, thereby fostering the inletting of light to the environments beneath the building 7 and anyhow eliminating the risk of a downward fall of maintenance staff.

Referring also to Figure 5, preferably the photovoltaic unit 1 comprises a plurality of aeration channels placed beneath the exposure wall 23. In the present example, such aeration channels are obtained by a fretted sheet metal element 13 arranged below the exposure wall 23 and fixed thereto.

The presence of said channels allows, in use, the generation of natural convective air motions by heat of the solar radiation incident on the exposure wall 23. Such convective motions beneath the photovoltaic panels 2 help to cool the surface of the panels themselves, markedly improving power production efficiency.

Referring now to the installation modes of a photovoltaic unit 1, in Figure 5 are also highlighted:
- the floor 9 of the plane roof on which the unit 1 itself is mounted,
- a pre-existing skylight 10, and
- a main bearing structure 11 of the pre-existing floor, onto said structure rests the mast-like frame 12, equipped with cross-beams 121, of unit 1.

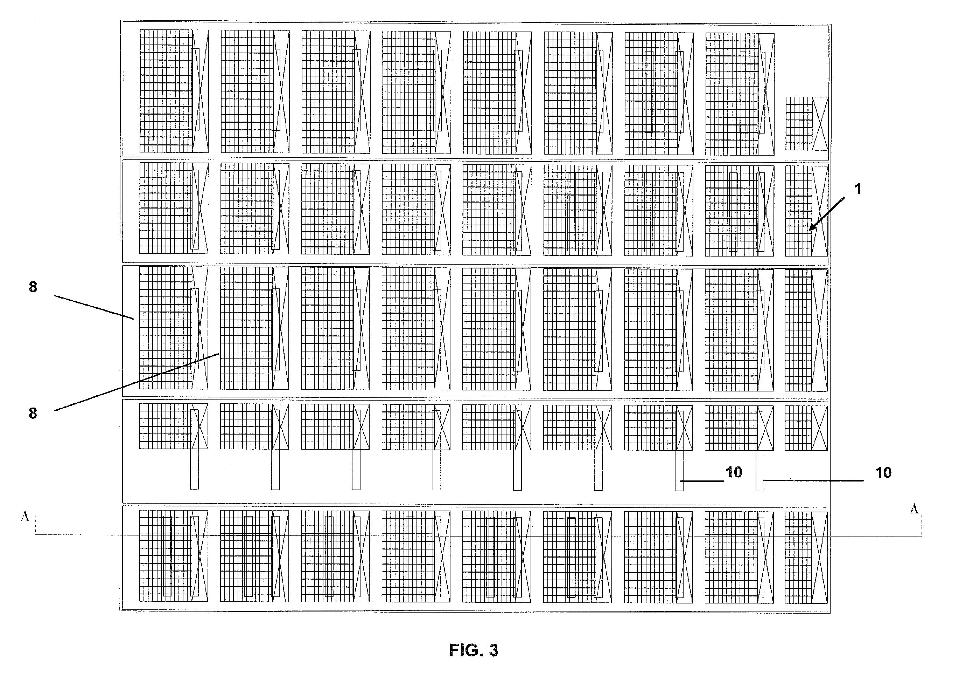

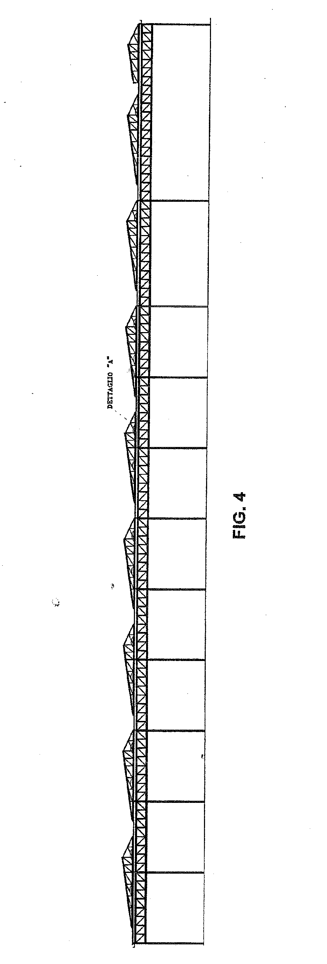

As shown in Figures 3 and 4, a preferred installation mode envisages a plurality of photovoltaic units 1 of the type described hereto, arranged side-by-side on a plane floor or roof, so as to cover the near-totality of the related surface, leaving one or more treadable spaces or paths 8 between one component 1 and the adjacent one to allow for any ordinary maintenance.

In the installation mode of said figures, the photovoltaic units 1 associate with said existing plane roof or floor.

According to a different mode to which Figure 5A refers, a substantial portion of the floor surface underlying the unit 1 is removed. In this case, representing a most preferred configuration of installation, the advantages of the component 1 are fully utilized, and in particular the fretted sheet metal 13 is replaced by a sandwich package 131 of fretted sheet metal coupled to insulating material, so as to restore and if necessary improve the thermal needs of the floor that is being replaced.

It will be appreciated that the weight added by installing the above-described photovoltaic units is comparable with the floor that is being replaced and, in case of need, the novel structures can cooperate with the existing ones to solve local structural problems.

In the configuration of Figure 5A, pre-existing aeration chimneys on the floor that is being replaced are eliminated and functionally replaced by the side walls 5 and 6 that, as mentioned above, ensure passive safety to a fire event, without introducing electronic devices that might not be available to activate themselves in case of fire. Therefore, at this point it will be better appreciated that the proposed photovoltaic unit constitutes a single member able to replace the plane coverings without further components, ensuring all functions (mechanical and water-tightness) previously entrusted to the part of plane covering it is intended to replace.

The presence of such channels obtained in particular by the fretted sheet metal 13 or the sandwich structure 131 - beneath the photovoltaic surface, and in general the above-described preferred embodiments, provide relevant advantages, such as:
- an improved thermal resistance, by implementing the concept of "ventilated roof', in which photovoltaic modules are cooled by convective air motions in the gaps of the fretted sheet metals;
- an improved insulation of the roof, with an entailed power saving;
- a water-tightness of the roof portion that is associated with, or replaced by, a photovoltaic unit 1;
- the possibility of incorporating the aeration chimneys, directing them up to the side walls of the photovoltaic unit 1;
- the prevention of falling, down to environments beneath, of any broken panels and/or of related fragments.

The present invention has hereto been described with reference to preferred embodiments thereof. It is understood that other embodiments might exist, all falling within the concept of the same invention, as defined by the protective scope of the claims hereinafter.

## Claims

1. A photovoltaic unit (1), apt to be installed at, or in replacement of, substantially plane floors, comprising:
- a plurality of photovoltaic panels (2); and
- a supporting structure (4) for said photovoltaic panels (2), said supporting structure (4) in turn having:
■ a tilted exposure wall (23) bearing, or made of, said photovoltaic panels (2) so as to be exposed, in use, to solar radiation; and
■ a plurality of side walls (5, 6) lateral to said exposure wall (23), each of which side walls (5, 6) has at least one transparent portion and is at least partly made of a self-extinguishing fire-retardant material.

2. The photovoltaic unit (1) according to claim 1, comprising a plurality of aeration channels placed beneath said exposure wall (23) and apt to allow, in use, a convective air motion generated by heat of the solar radiation incident on said exposure wall (23).

3. The photovoltaic unit (1) according to the preceding claim, wherein said aeration channels are obtained by a fretted sheet metal element (13) arranged below said exposure wall (23).

4. The photovoltaic unit (1) according to any one of the preceding claims, wherein one or more of said side walls (5, 6) are made of self-extinguishing polycarbonate.

5. The photovoltaic unit (1) according to any one of the preceding claims, wherein one or more of said side walls (5, 6) has shockproof properties.

6. The photovoltaic unit (1) according to any one of the preceding claims, wherein one or more of said side walls (5, 6) has properties of transparency to diffused light.

7. The photovoltaic unit (1) according to any one of the preceding claims, wherein one or more of said side walls (5, 6) comprises a lattice-shaped fall prevention member.

8. The photovoltaic unit (1) according to the preceding claim, wherein said fall prevention member is a wire netting.

9. A building for industrial use, comprising one or more photovoltaic units (1) according to any one of the preceding claims.
